# EUROPÄISCHE PATENTSCHRIFT

(11) **EP 4 142 075 B1**
(45) Veröffentlichungstag und Bekanntmachung des Hinweises auf die Patenterteilung: **11.12.2024**
(21) Anmeldenummer: 21193070.6
(22) Anmeldetag: 25.08.2021
(51) Int. Cl.: H01S 5/042, H01S 5/062, H01S 5/026, G01S 7/484, G01S 17/02, G01S 17/10

(54) **LASERDIODENSCHALTUNG**
LASER DIODE CIRCUIT
CIRCUIT DE DIODE LASER

(43) Veröffentlichungstag der Anmeldung: 01.03.2023
(73) Patentinhaber: RIEGL Laser Measurement Systems GmbH, 3580 Horn (AT)
(72) Erfinder: TRAXLER, Christoph, 3912 Grafenschlag (AT); HOFBAUER, Andreas, 3910 Zwettl (AT)
(74) Vertreter: Weiser & Voith Patentanwälte Partnerschaft

(56) Entgegenhaltungen:
- WO-A1-2021/051762
- JP-A- 2009 260 030
- US-A1- 2003 016 711
- US-B1- 9 368 936

## Beschreibung

Die vorliegende Erfindung betrifft eine Laserdiodenschaltung umfassend einen an eine Spannungsquelle anschließbaren Ladekreis mit einem Kondensator und einen vom Ladekreis gespeisten Lastkreis mit einer Laserdiode in Durchlassrichtung, wobei der Lastkreis dem Kondensator parallelgeschaltet ist und einen steuerbaren ersten Schalter in Serie mit der Laserdiode aufweist, und wobei der Ladekreis in Serie eine Spule, ein Strom zum Kondensator hin durchlassendes und in der Gegenrichtung sperrendes elektronisches Element und den genannten Kondensator aufweist.

Laserdiodenschaltungen dieser Art sind aus der WO 2021/051762 A1, JP 2009-260030 A oder der US 9,368,936 B1 bekannt und werden beispielsweise in Hochleistungs-Laserscannern zur topographischen Vermessung von Landschaften, Straßenzügen, Bergwerken, Tunnels oder Gewässern verwendet. Die Erzeugung hochenergetischer, ultrakurzer Laserimpulse im Nanosekundenbereich mit einer hohen Repetitions- bzw. Taktrate ist dabei entscheidend, um auch weit entfernte Oberflächen rasch und mit hoher Ortsauflösung vermessen zu können.

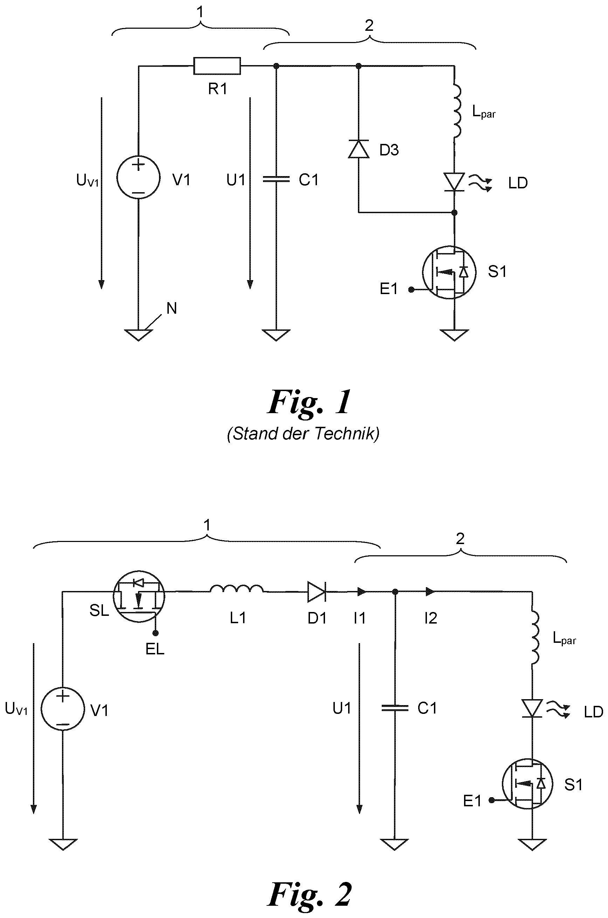

Fig. 1 zeigt eine typische derartige Laserdiodenschaltung nach dem Stand der Technik. Die Laserdiodenschaltung setzt sich aus einem Ladekreis 1 für einen Kondensator C1 und einen vom Ladekreis 1, genauer dessen Kondensator C1, gespeisten Lastkreis 2 zusammen, welcher die Laserdiode LD enthält. Wie ersichtlich teilen sich der Ladekreis 1 und der Lastkreis 2 den Kondensator C1, d.h. die Spannung U1 am Kondensator C1 und damit am Ausgang des Ladekreises 1 gegenüber Massepotential N ist gleichzeitig die Eingangs- und Speisespannung des Lastkreises 2 mit der Laserdiode LD.

Der Ladekreis 1 ist an eine Spannungsquelle V1 anschließbar (oder umfasst diese). Die Spannungsquelle V1 lädt den Kondensator C1 über einen Ladewiderstand R1. Der Lastkreis 2 umfasst einen mit der Laserdiode LD in Serie liegenden steuerbaren Schalter S1 mit einem Steuereingang E1. Durch Schließen des Schalters S1, gesteuert durch ein entsprechendes Signal am Steuereingang E1, wird der Lastkreis 2 geschlossen und der vom Ladekreis 1 geladene Kondensator C1 über die Laserdiode LD entladen, wodurch diese einen Laserimpuls abgibt.

Die im Lastkreis 2 in Serie mit der Laserdiode LD dargestellte Summeninduktivität Lₚₐᵣ stellt vereinfachend die Summe aller im Lastkreis 2 auftretenden Induktivitäten dar und umfasst die in der Realität räumlich verteilten parasitären Bauteil-, Leitungs- und Streuinduktivitäten im Lastkreis 2. Die der Serienschaltung aus Summeninduktivität Lₚₐᵣ und Laserdiode LD antiparallel geschaltete Diode D3 dient dabei dem Schutz der Laserdiode LD vor nachteiligen Auswirkungen einer negativen Spannung, die gegen Ende des Entladestromimpulses an Lₚₐᵣ induziert wird.

Ein wesentlicher Nachteil der bekannten Laserdiodenschaltung von Fig. 1 ist die am Ladewiderstand R1 anfallende Verlustenergie. Diese ist etwa gleich groß wie die am Ende des Ladevorgangs im Kondensator C1 gespeicherte Energie, was den theoretisch maximalen Wirkungsgrad dieser Schaltung auf etwa 50% begrenzt. Insbesondere bei der Nutzung von Laserdioden LD mit hohen Repetitionsraten und hohen Laserleistungen stellt die Verlustleistung des Ladekreises 1 einen wesentlichen Anteil am Gesamtleistungsbedarf der Laserdiodenschaltung dar und muss durch aufwändige Kühlmaßnahmen aus dem Gerät abgeleitet werden. Auch die in der Schaltung von Fig. 1 notwendige Schutzdiode D3, welche die am Ende des Laserimpulses in der Summeninduktivität Lₚₐᵣ gespeicherte Restenergie in thermische Verlustleistung umwandelt, verschlechtert den Wirkungsgrad signifikant.

Die Erfindung setzt sich zum Ziel, die Nachteile des bekannten Standes der Technik zu überwinden und eine Laserdiodenschaltung mit verbessertem Wirkungsgrad zu schaffen.

Dieses Ziel wird mit einer Laserdiodenschaltung der eingangs genannten Art erreicht, welche sich erfindungsgemäß dadurch auszeichnet, dass der Lastkreis eine der Laserdiode in derselben Durchlassrichtung vor- oder nachgeschaltete zweite Diode, die keine Laserdiode ist, oder einen der Laserdiode vor- oder nachgeschalteten Trennschalter aufweist, der dazu ausgebildet ist, am Ende des Umladevorgangs, wenn ein negatives Potential an der Laserdiode anliegen würde, aufgetrennt zu werden, um die Laserdiode zu schützen.

Gemäß der Erfindung kann die in der parasitären Summeninduktivität des Lastkreises gespeicherte Restenergie, welche im Stand der Technik zum Schutz der Laserdiode in der Schutzdiode D3 (Fig. 1) vernichtet werden muss, für den Betrieb der Laserdiode ausgenützt bzw. wiederverwertet werden. Dazu wird in einer ersten Ausführungsform der Laserdiode im Lastkreis eine zweite Diode in derselben Durchlassrichtung vor- oder nachgeschaltet. Diese zweite Diode kann, weil sie keine Laserdiode ist, mit einer besonders hohen Spannungsfestigkeit in Sperrrichtung und besonders hohem Sperrwiderstand ausgestattet werden, sodass in jener Phase des Stromflusses im Lastkreis, wenn das Magnetfeld in der parasitären Summeninduktivität zusammenbricht und weiteren Stromfluss treibt, der den Kondensator auf negatives Potential umlädt, die Laserdiode vor einer zu hohen Negativspannung geschützt werden. Durch den Entfall der der Laserdiode antiparallelen Schutzdiode (D3 in Fig. 1) kann damit auch die Restenergie im Lastkreis-Serienschwingkreis, der sich durch den Kondensator und die parasitäre Summeninduktivität bildet, zum Umladen des Kondensators auf negatives Potential ausgenützt werden, sodass der nächste Ladevorgang von diesem negativen Potential aus beginnend durchgeführt werden kann. Damit kann wiederum einerseits Verlustleistung eingespart und anderseits eine Spannungsquelle geringerer Ausgangsspannung oder ein kleinerer Kondensator bei gleicher Ladeleistung verwendet oder eine höhere Ladeleistung bei gleichem Kondensatorvolumen erreicht werden.

Anstelle der genannten zweiten Diode im Lastkreis kann in einer zweiten Ausführungsform auch ein der Laserdiode vor- oder nachgeschalteter Trennschalter verwendet werden, welcher genau zum richtigen Zeitpunkt, d.h. am Ende des Umladevorgangs des Kondensators, wenn das negative Potential an der Laserdiode anliegen würde, ausgeschaltet bzw. aufgetrennt wird, um die Laserdiode zu schützen.

In der Laserdiodenschaltung wird im Ladekreis anstelle eines verlustbehafteten Ladewiderstands eine Serienschaltung aus einer Spule und einem als Diode wirkenden Element verwendet. Dadurch wird der Ladekreis zu einem auf die erste Halbwelle limitierten Serienschwingkreis aus Spule und Kondensator. Dies ergibt gleichzeitig eine Spannungsverdoppelungsschaltung, weil die in der Spule gespeicherte magnetische Energie, nachdem der Kondensator das Potential der Spannungsquelle erreicht hat, beim Zusammenbrechen des Magnetfeldes einen fortgesetzten Stromfluss zum Kondensator hin induziert und diesen so auf annähernd das Doppelte des Potentials der Spannungsquelle weiterlädt. Die Verlustleistung der erfindungsgemäßen Ladeschaltung ist nur ein Bruchteil gegenüber der Verwendung eines Ladewiderstands und ist im Wesentlichen nur durch die Verluste an dem Diodenelement und durch den Leitungswiderstand und die Magnetisierungsverluste der Spule bedingt. Durch die doppelte Ladespannung des Kondensators kann z.B. die Ausgangsspannung der Spannungsquelle auf die Hälfte reduziert und somit eine kleinere Spannungsquelle verwendet werden. Alternativ kann bei unveränderter Spannungsquelle mit einem Kondensator mit einem Viertel der Kapazität die gleiche Ladeenergie oder umgekehrt bei gleichem Kondensator die vierfache Ladeenergie erzielt werden, was den Bauraumbedarf bzw. die Leistung der Schaltung im Vergleich zum Stand der Technik beträchtlich verbessert.

Das den Strom zum Kondensator hin durchlassende und in der Gegenrichtung sperrende elektronische Element kann auf beliebige Weise realisiert sein, beispielsweise in Form eines entsprechend gesteuerten elektronischen Schalters. Bevorzugt ist das elektronische Element jedoch eine erste Diode, was den Bauteilebedarf reduziert.

Der Serienschwingkreis im Ladekreis kann in einer besonders vorteilhaften Ausführungsform der Erfindung auch in der Art einer Ladungspumpe eingesetzt werden, indem im Ladekreis bevorzugt ein steuerbarer zweiter Schalter angeordnet wird, welcher der Serienschaltung aus elektronischem Element und Kondensator parallelgeschaltet ist. Durch Schließen des zweiten Schalters zu Beginn der Ladephase wird gleichsam der Kondensator überbrückt, sodass das an der Spule anliegende Potential während des Aufbaus des Stromflusses und damit Magnetfelds in der Spule unvermindert der Spannung der Spannungsquelle entspricht. Die in der Spule auf diese Weise gespeicherte Magnetenergie, welche beim Öffnen des zweiten Schalters dann in einen Ladestrom und damit einen Ladungstransport in den Kondensator kommutiert, kann somit durch die Schließdauer des zweiten Schalters gewählt werden. Durch wiederholtes Schließen des zweiten Schalters kann die Ladespannung des Kondensators auch noch weiter erhöht werden, in der Art einer Ladungspumpe.

Im Zusammenhang mit der Ansteuerung einer Laserdiode eröffnet diese Einstellbarkeit der Ladespannung des Kondensators auch die Möglichkeit, die Amplitude bzw. Leistung der Laserimpulse von Impuls zu Impuls zu variieren, z.B. entsprechend einer gewünschten Modulation. So kann beispielsweise die Impulsleistung eines Laserscanners, der Laserimpulse über einen Scanfächer verteilt auf einen ebenen Boden aussendet, in den Randbereichen des Fächers, wo die Zielentfernung größer ist, erhöht werden, oder allgemein die Impulsleistung für einen nächsten auszusendenden Laserimpuls an die mit einem vorangegangenen Laserimpuls gemessene Zielentfernung angepasst werden.

Eine für diesen Zweck besonders bevorzugte Ausführungsform der erfindungsgemäßen Laserdiodenschaltung weist einen Impulsgenerator auf, der dafür ausgebildet ist, den ersten Schalter mit einer ersten Folge von Steuerimpulsen einer Taktrate und den zweiten Schalter mit einer zweiten, der ersten vorauseilenden Folge von Steuerimpulsen derselben Taktrate oder eines Vielfachen davon und jeweils einer Impulsbreite zu steuern, die der jeweils aktuellen Amplitude eines Modulationssignals entspricht. Das Modulationssignal steuert so die Einschaltzeiten des zweiten Schalters im Ladekreis und damit die Ladespannung des Kondensators entsprechend der Amplitude eines z.B. in die Laserdiodenschaltung eingespeisten Modulationssignals, welches beispielsweise der Winkelrichtung der Laserimpulse in einem Scanfächer, vorangegangenen Entfernungsmesswerten oder anderen Vorgaben folgt.

Die genannte Einstellbarkeit der Ladespannung des Kondensators durch Variieren seiner Schließdauer bzw. der Impulsbreite seines Ansteuersignals kann überdies auch dazu verwendet werden, Schwankungen der Spannung der Spannungsquelle zu kompensieren. Eine weitere bevorzugte Ausführungsform der Erfindung zeichnet sich demgemäß durch eine Kompensationsschaltung aus, welche dafür ausgebildet ist, das Modulationssignal umgekehrt proportional zur Spannung der Spannungsquelle zu verändern. Dadurch können nicht nur Schwankungen einer unzuverlässigen Spannungsquelle kompensiert werden, sondern auch Spannungsquellen kleiner Leistung bzw. mit hohem Innenwiderstand verwendet werden, die beispielsweise lediglich durch einen der Spannungsquelle parallelgeschalteten Pufferkondensator gepuffert sind. Solche kondensatorgepufferte Spannungsquellen erleiden in jedem Ladezyklus mit fortgesetzter Stromentnahme einen Spannungsabfall "by design", welcher nunmehr durch die erfindungsgemäße Schaltung kompensiert werden kann. Im Ergebnis können besonders kleine, bloß durch einen Pufferkondensator abgepufferte Spannungsquellen verwendet werden.

Es versteht sich, dass die Impulsbreitensteuerung des zweiten Schalters auch ausschließlich zur Kompensation solcher Spannungsquellenschwankungen verwendet werden kann, d.h. das Modulationssignal selbst keiner externen Vorgabe folgt, sondern einzig von einem Messwert der Spannung der Spannungsquelle abhängt. Anderseits ist es möglich, die Impulsbreitensteuerung des zweiten Schalters für beide Maßnahmen gleichzeitig zu verwenden, d.h. ein an einem Modulationseingang des Impulsgenerators empfangenes externes Modulationssignal zusätzlich abhängig von der Spannung der Spannungsquelle zu verändern.

Der Ladekreis kann permanent in Betrieb sein, d.h. jedesmal nach Abgabe eines Laserimpulses, wenn der erste Schalter nach der Impulsabgabe wieder geöffnet wurde, sofort wieder mit dem Laden des Kondensators beginnen. Falls gewünscht, kann der Ladekreis jedoch auch einen der Spule oder ersten Diode vor- oder nachgeschalteten Ladeschalter aufweisen, der erst dann geschlossen wird, wenn mit dem Aufladen des Kondensators begonnen werden soll.

Die Erfindung wird nachstehend anhand von in den beigeschlossenen Zeichnungen dargestellten Ausführungsbeispielen näher erläutert. In den Zeichnungen zeigen:
Fig. 1 eine Laserdiodenschaltung gemäß dem Stand der Technik in einem Schaltbild;
Fig. 2 eine erste Ausführungsform der Laserdiodenschaltung der vorliegenden Offenbarung in einem Schaltbild;
Fig. 3 den Strom- und Spannungsverlauf beim Laden des Kondensators im Ladekreis der Laserdiodenschaltung von Fig. 2 in einem Zeitdiagramm;
Fig. 4 eine zweite Ausführungsform der Laserdiodenschaltung der vorliegenden Offenbarung in einem Schaltbild;
die Fig. 5a und 5b die Strom- und Spannungsverläufe im Lastkreis der Laserdiodenschaltung von Fig. 4 jeweils in einem Zeitdiagramm;
die Fig. 6a und 6b die Strom- und Spannungsverläufe der Fig. 5a und 5b über einen größeren Zeitraum, welcher auch die Ladephase umfasst, nach Abgabe eines Laserimpulses, jeweils in einem Zeitdiagramm, wobei Fig. 6b auch den Stromverlauf im Ladekreis wiedergibt;
Fig. 7 eine dritte Ausführungsform der Laserdiodenschaltung der vorliegenden Offenbarung in einem Schaltbild;
Fig. 8 die Strom und Spannungsverläufe im Ladekreis der Laserdiodenschaltung von Fig. 7 in der Ladephase in einem Zeitdiagramm;
die Fig. 9a bis 9c Amplituden/Zeit-Diagramme von Steuerimpulsen für den ersten Schalter (Fig. 9a) und den zweiten Schalter (Fig. 9b) der Laserdiodenschaltung von Fig. 7 sowie von damit erzeugten Laserimpulsen (Fig. 9c); und
die Fig. 10a und 10c zeigen zwei erfindungsgemäße Varianten der Laserdiodenschaltung von Fig. 4 zum Schutz der Laserdiode vor zu hohen Sperrspannungen jeweils in einem Schaltbild.

Betreffend Fig. 1 wird auf die Beschreibung in der Einleitung verwiesen. Gleiche Bezugszeichen bezeichnen gleiche Teile in allen Figuren. Die Beschreibung der Fig. 2 bis 10 baut auf der Beschreibung der Fig. 1 auf und im Weiteren werden nur die Unterschiede gegenüber Fig. 1 erläutert.

Fig. 2 zeigt eine erste Ausführungsform der Laserdiodenschaltung der vorliegenden Offenbarung. Im Ladekreis 1 ist anstelle des Ladewiderstandes R1 von Fig. 1 eine Serienschaltung aus einer Spule L1 und einer ersten Diode D1 angeordnet, welche in Durchlassrichtung zum Kondensator C1 hin gepolt ist. In die Serienschaltung aus Spule L1 und Diode D1 kann an beliebiger Stelle ein Ladeschalter SL zwischengeschaltet sein, beispielsweise vor oder nach der Spule L1 oder Diode D1. Der Ladeschalter SL hat einen Steuereingang für ein Steuersignal EL, mit welchem der Ladekreis 1 zwecks Ladens des Kondensators C1 aus der Spannungsquelle V1 über die Spule L1 und die Diode D1 geschlossen wird. Der Schalter S1 im Lastkreis 1 ist beim Laden des Kondensators C1 geöffnet. Die Spannungsquelle V1 kann wie erörtert Bestandteil der Laserdiodenschaltung sein oder nicht (d.h. extern).

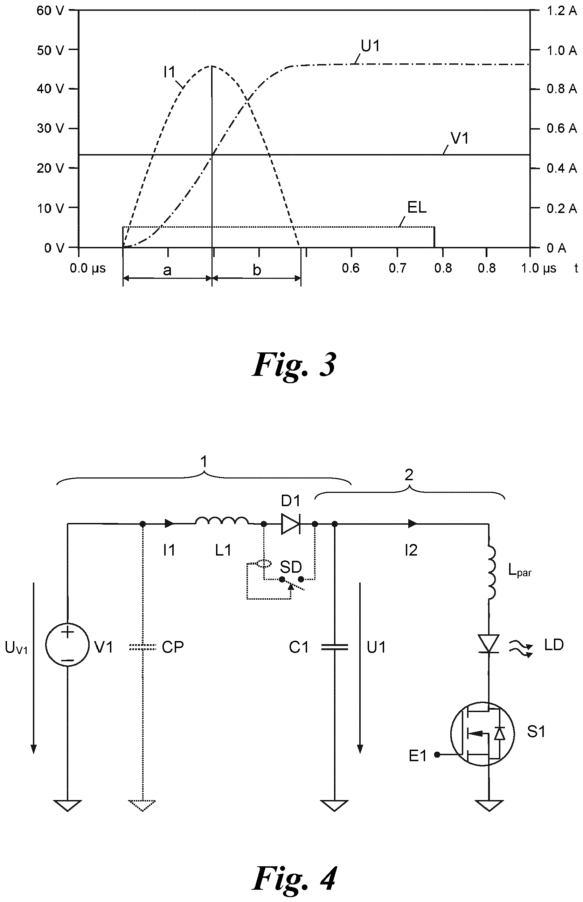

Fig. 3 zeigt den Verlauf des Stromes I1 im Ladekreis 1 und der Spannung U1 am Kondensator C1 in der Ladephase, d.h. nach dem Schließen des Schalters SL. Die angegebenen Werte für Strom, Spannung und Zeit t sind selbstverständlich nur beispielhaft.

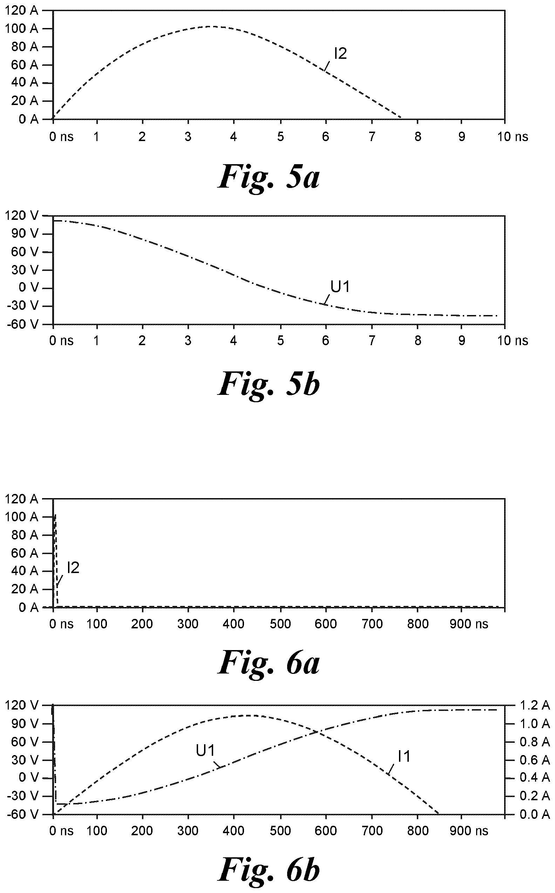

Nachdem zum Zeitpunkt t = 0 ein Laserimpuls durch Schlie-ßen des Schalters S1 von der Laserdiode LD abgegeben worden ist (in Fig. 3 nicht dargestellt, siehe dazu später Fig. 5a - 6b) und die Spannung U1 am Kondensator C1 entsprechend abgesunken ist, wird der Nachladevorgang durch Schließen des Ladeschalters SL ausgelöst. Der Ladestrom I1 steigt zunächst sinusförmig an, bis die Spannung U1 die Spannung U_{V1} der Spannungsquelle V1 erreicht (erste Ladephase a). In der anschließenden zweiten Ladephase b wird der Strom I1 durch das an der Spule L1 zusammenbrechende Magnetfeld weitergetrieben und treibt die Ladespannung U1 annähernd auf das Doppelte der Spannung U_{V1} der Spannungsquelle VI, bis der Strom I1 abgeklungen ist.

Wie aus Fig. 3 ersichtlich, ist der Ladestrom I1 durch L1 halbsinusförmig. Die Dauer dieses halben Sinusverlaufs wird im Wesentlichen durch die Induktivität der Spule L1 und die Kapazität des Kondensators C1 bestimmt. Da die Kapazität des Kondensators C1 meist durch die erforderliche Pulsenergie der Laserdiode LD vorgegeben ist, kann die Ladedauer a + b durch die Wahl von L1 einfach an die maximal verfügbare Ladezeit bzw. die erforderliche Repetitionsrate der Laserimpulse angepasst werden.

Fig. 4 zeigt eine vereinfachte Ausführungsform der Laserdiodenschaltung von Fig. 2 ohne Ladeschalter SL. Denn der Schalter SL kann insbesondere dann entfallen, wenn das Nachladen des Kondensators C1 unmittelbar nach dem Entladen (und nicht erst nach einer Verzögerung) erfolgen darf bzw. soll.

Fig. 4 zeigt auch die optionale Variante, dass anstelle der ersten Diode D1 ein beliebiges elektronisches Element verwendet wird, welches Strom in Richtung zum Kondensator C1 hin durchlässt und in der Gegenrichtung sperrt. Beispielsweise ist dieses elektronische Element ein elektronischer Schalter SD, der so gesteuert ist, dass er diese Diodenfunktion ausübt. In einer weiteren (nicht dargestellten) Variante könnte das elektronische Element auch durch den Ladeschalter SL (Fig. 2) selbst gebildet sein, wenn dieser entsprechend gesteuert ist.

Die Fig. 5a und 5b sowie 6a und 6b zeigen die Zeitverhältnisse bei der Laserimpulsabgabe und beim Nachladen im Detail. Eine beispielhafte Impulsrepetitionsrate von 1 MHz stellt 1 µs Zeit zum Nachladen des Kondensators C1 zur Verfügung, siehe Fig. 6b. Die Impulsdauer eines Laserimpulses der Laserdiode LD beträgt im gezeigten Beispiel ca. 8 ns, siehe Fig. 5a. Der Schalter S1 zum Triggern eines Laserimpulses könnte an sich nur für die Dauer des Laserimpulses, z.B. (hier) 8 ns, geschlossen werden. Zum Ausnützen der in der Summeninduktivität Lₚₐᵣ gespeicherten Restenergie wird der Schalter S1 jedoch solange geschlossen, bis diese Restenergie, welche den Strom I2 nach dem Zusammenbruch der Spannung U1 noch weiter treibt, den Kondensator C1 umgeladen hat, auf etwa annähernd die negative Spannung U1, z.B. (hier) -45 V.

Für den nun anschließenden nächsten Ladevorgang wird der Schalter S1 geöffnet. Dieser anschließende Ladevorgang beginnt nun bei einer negativen Spannung U1 von -45 V am Kondensator C1, welche nun wieder wie erörtert vom Ladekreis 1 invertiert und um das Doppelte der Spannung U_{V1} der Spannungsquelle V1 angehoben wird, hier auf ca. 95 V. Der ausnützbare Spannungshub am Kondensator C1 beträgt damit ca. 140 V, ein Vielfaches der Spannung U_{V1} der Spannungsquelle V1 (hier: 25 V) .

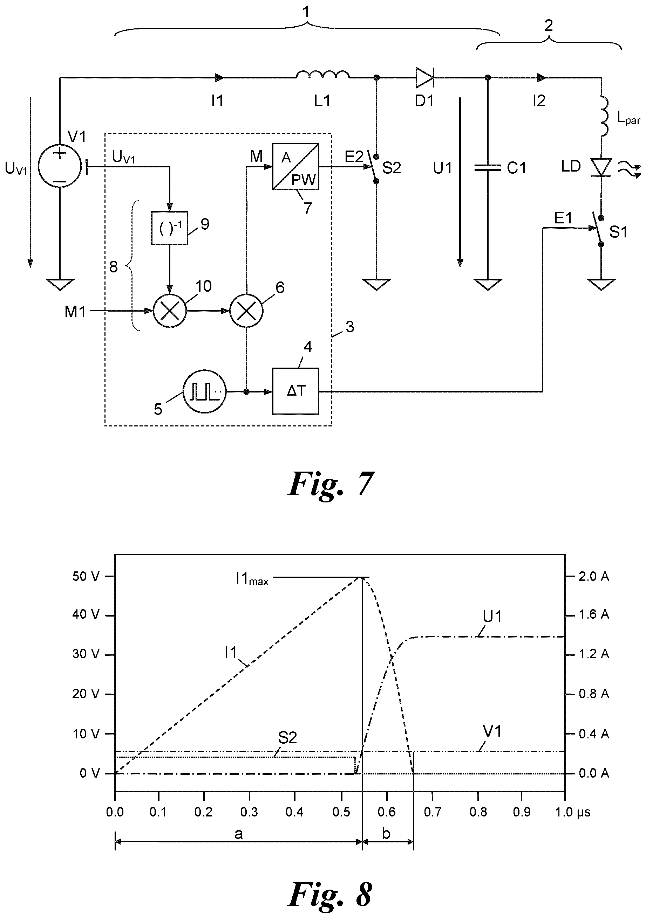

Fig. 7 zeigt eine weitere Ausführungsform der Laserdiodenschaltung mit einem steuerbaren zweiten Schalter S2, der im Ladekreis 1 parallel zur Serienschaltung aus elektronischem Element (Diode D1 oder Schalter SD bzw. SL) und Kondensator C1 liegt. Mithilfe des Schalters S2 können in der ersten Phase a des Ladevorgangs des Kondensators C1 die Diode D1 und der Kondensator C1 überbrückt werden, d.h. die Spule L1 auf Masse geschlossen werden, wodurch der Spulenstrom I1 gleichsam ungehindert - in den Systemgrenzen des Innenwiderstands der Spannungsquelle V1 und des Leitungswiderstandes der Spule L1 - linear ansteigen kann, sodass sein Endwert I1ₘₐₓ von der Schließdauer a des Schalters S2 abhängt, siehe Fig. 8. Die auf diese Weise in der Spule L1 gespeicherte magnetische Energie wird nach dem Öffnen des Schalters S2 in der anschließenden Phase b des Zusammenbruchs des Magnetfelds in die Ladung des Kondensators C1 und damit den weiteren Aufbau der Spannung U1 kommutiert. Die Ladespannung U1 des Kondensators C1 am Ende der Ladephase a + b ist damit proportional der Schließdauer a des Schaltes S2, also der Impulsbreite PW eines am Steuereingang E2 des Schalters S2 angelegten Steuerimpulses zum Schließen des Schalters S2.

Falls gewünscht, könnte durch Wiederholen der Ladephase a + b, bevor der Kondensator C1 für den nächsten Laserimpuls entladen wird, die Spannung U1 am Kondensator C1 noch weiter erhöht werden, in der Art einer Ladungspumpe. Im einfachsten Fall, insbesondere wenn bei einer hohen Impulswiderholrate der Laserimpulse zwischen zwei Laserimpulsen nur Zeit für eine einzige Ladephase a + b zur Verfügung steht, wird nur eine solche Ladephase pro Laserimpuls durchgeführt.

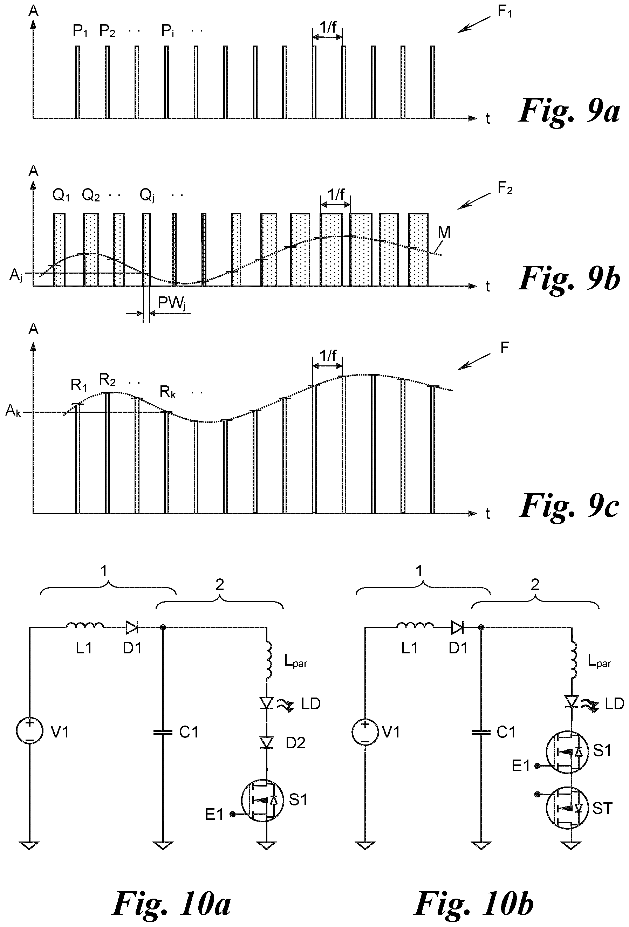

Die Laserdiodenschaltung von Fig. 7 kann aufgrund der Einstellbarkeit der Ladespannung U1 und damit der Speisespannung der Laserdiode LD pro Laserimpuls auch dazu verwendet werden, eine Folge von Laserimpulsen in ihrer Amplitude bzw. Impulsleistung zu modulieren, wie anhand der Fig. 9a bis 9c näher erläutert wird.

Für die Abgabe einer Folge F von Laserimpulsen R₁, R₂, ..., allgemein Rₖ, mit einer Taktrate ("pulse repetition rate", PRR) f (Fig. 9c) erzeugt ein Impulsgenerator 3 eine erste Folge F₁ von Steuerimpulsen P₁, P₂, ..., allgemein Pᵢ (Fig. 9a). Die Steuerimpulse Pᵢ werden dem Steuereingang E1 des Schalters S1 zugeführt, um jeweils einen Laserimpuls Rᵢ durch die Laserdiode LD abzugeben.

Zur Steuerung des zweiten Schalters S2 erzeugt der Impulsgenerator 3 gleichzeitig eine zweite Folge F₂ von Steuerimpulsen Q₁, Q₂, ..., allgemein Qⱼ (Fig. 9b). Die Taktrate f der Steuerimpulse Qⱼ für den zweiten Schalter S2 ist gleich der Taktrate f der Steuerimpulse Pᵢ für den ersten Schalter S1 (oder ein ganzzahliges Vielfaches davon, wenn mehrere Ladephasen a + b pro Laserimpuls Rᵢ zur Vervielfachung der Ladespannung U1 gewünscht sind). Die Steuerimpulse Qⱼ eilen den Steuerimpulsen Pᵢ dabei jeweils voraus, versinnbildlicht durch ein Zeitverzögerungsglied 4 zwischen einem Generator 5 für den Takt f des Impulsgenerators 3 und dem Eingang E1 des Schalters S1.

Es versteht sich, dass der hier verwendete Begriff "Taktrate" nicht notwendigerweise eine zeitlich konstante Taktrate bezeichnet; die Taktrate f kann auch über die Zeit variieren (sog. PRR-Variation).

Die Impulsbreite PWⱼ der Steuerimpulse Qⱼ des zweiten Schalters S2 wird dabei jeweils entsprechend einer gewünschten Amplitude Aₖ der von der Laserdiode LD abgegebenen Laserimpulse Rₖ vorgegeben, um die jeweilige Ladespannung U1 des Kondensators C1 für den jeweils nächsten Laserimpuls Pₖ einzustellen. Damit kann beispielsweise ein Modulationssignal M an einem Modulationseingang M1 des Impulsgenerators 3, amplitudenmoduliert auf die Ausgangsimpulse des Generators 5 in einem Mischer 6 und umgewandelt in einem Amplituden/Pulsbreiten-Wandler 7 in die impulsbreitenmodulierte Folge F₂ von Steuerimpulsen Qⱼ, über den Ladekreis 1 in der genannte Weise die Ladespannung U1 für jeden Laserimpuls Rₖ der Ausgangsfolge F und damit die Laserleistung des Laserimpulses Rₖ modulieren, siehe Fig. 9c.

Die Impulsbreitenvariation des Steuersignals des zweiten Schalters S2 kann - alternativ oder zusätzlich zu dem erörterten Folgen eines am Modulationseingang M1 eingespeisten Modulationssignals M - auch dazu verwendet werden, Schwankungen der Spannung U_{V1} der Spannungsquelle V1 zu kompensieren. Diesem Zweck dient eine optionale Kompensationsschaltung 8, welche das Modulationssignal M abhängig von der Spannung U_{V1} der Spannungsquelle V1 verändert, und zwar insbesondere umgekehrt proportional dazu. Die Kompensationsschaltung 8 hat beispielsweise einen Kehrwertbildner 9, dem ein Messsignal der Spannung U_{V1} der Spannungsquelle V1 an seinem Eingang zugeführt wird und welcher über einen weiteren Mischer 10 das Modulationssignal M entsprechend verändert.

In dem in Fig. 7 gezeigten Beispiel wird ein am Modulationseingang M1 eingespeistes (externes) Modulationssignal, das beispielsweise der Winkelrichtung der Laserimpulse in einem Scanfächer, vorangegangenen Entfernungsmesswerten oder anderen Vorgaben folgt, durch den weiteren Mischer 10 zwecks Kompensation von Schwankungen der Spannungsquelle V1 seinerseits moduliert. Wenn jedoch nur eine Kompensation von Schwankungen der Spannungsquelle V1 gewünscht ist, kann der Modulationseingang M1 entfallen und die Kompensationsschaltung 8 direkt die Impulsbreite des Steuersignals des zweiten Schalters S2 steuern, beispielsweise indem der Ausgang des Kehrwertbildners 9 direkt in den Mischer 6 eingespeist wird.

Die Kompensationsschaltung 8 kann auch auf andere Art als durch einen Kehrwertbildner 9 und Mischer 10 realisiert werden, beispielsweise durch einen Signalprozessor, der eine Regelung implementiert, welche als Regelungsziel ein Konstanthalten der am Ende der Ladephase a + b erreichten Spannung U1 am Kondensator C1 unabhängig von der Spannung U_{V1} der Spannungsquelle V1 hat.

Wie oben erläutert gibt es am Ende jeder Laserimpulsabgabe durch die parasitäre Summeninduktivität Lₚₐᵣ im Lastkreis 2 eine Umladephase des Kondensators C1 auf annähernd die negative Ladespannung U1. Diese liegt am Ende der Umladephase in Sperrrichtung an der Laserdiode LD an. Wenn der Schalter S1 ein Halbleiterschalter ist, der nur in einer Richtung, nämlich in Durchlassrichtung der Laserdiode LD, sperren kann und in der entgegengesetzten Richtung, der Sperrrichtung der Laserdiode LD, durchlässig ist, liegt die negative Ladespannung des Kondensators C1 im Wesentlichen zur Gänze an der Laserdiode LD an. Herkömmliche Laserdioden, die eine geringe Sperrspannungsfestigkeit haben, könnten dadurch Schaden erleiden. Die in den Fig. 10a und 10b gezeigten erfindungsgemäßen Varianten von Schutzschaltungen im Lastkreis 2, die mit allen vorgenannten Ausführungsformen der Laserdiodenschaltung kombiniert werden können, schützen die Laserdiode LD vor einer solch übermäßigen Sperrspannung am Ende der Laserimpulsabgabephase und am Anfang der Ladephase a + b, solange die Spannung U1 am Kondensator C1 noch negativ ist.

Gemäß Fig. 10a kann dazu eine zweite Diode D2 der Laserdiode LD im Lastkreis 2 in derselben Durchlassrichtung vor- oder nachgeschaltet werden. Für die Diode D2 wird eine Arbeitsdiode mit hoher Sperrspannungsfestigkeit und hohem Sperrwiderstand gewählt, sodass die negative Spannung U1 überwiegend an der Diode D2 und nicht an der Laserdiode LD abfällt.

Fig. 10b zeigt eine alternative Ausführungsform mit einem Trennschalter ST anstelle der zweiten Diode D2, hier einem zweiten Halbleiterschalter, der im gesperrten Zustand eine dem (hier als Halbleiterschalter ausgeführten) ersten Schalter S1 entgegengesetzte Durchlassrichtung hat. Der Trennschalter ST wird gemeinsam mit dem Schalter S1 zur Abgabe eines Laserimpulses geschlossen und genau dann geöffnet, wenn das beim Umladen des Kondensators C1 nach Abgabe eines Laserimpulses auftretende negative Potential U1 die Laserdiode LD gefährden könnte.

Die Erfindung ist nicht auf die dargestellten Ausführungsformen beschränkt, sondern umfasst alle Varianten, Modifikationen und deren Kombinationen, die in den Rahmen der angeschlossenen Ansprüche fallen.

## Patentansprüche

1. Laserdiodenschaltung, umfassend einen an eine Spannungsquelle (V1) anschließbaren Ladekreis (1) mit einem Kondensator (C1) und einen vom Ladekreis (1) gespeisten Lastkreis (2) mit einer Laserdiode (LD) in Durchlassrichtung,
wobei der Lastkreis (2) dem Kondensator (C1) parallelgeschaltet ist und einen steuerbaren ersten Schalter (S1) in Serie mit der Laserdiode (LD) aufweist, und
wobei der Ladekreis (1) in Serie eine Spule (L1), ein Strom zum Kondensator (C1) hin durchlassendes und in der Gegenrichtung sperrendes elektronisches Element (D1, SD, SL) und den Kondensator (C1) aufweist, **dadurch gekennzeichnet,**
**dass** der Lastkreis (2) eine der Laserdiode (LD) in derselben Durchlassrichtung in Serie vor- oder nachgeschaltete zweite Diode (D2), die keine Laserdiode ist, oder einen der Laserdiode (LD) in Serie vor- oder nachgeschalteten Trennschalter (ST) aufweist, der dazu ausgebildet ist, am Ende des Umladevorgangs, wenn ein negatives Potential an der Laserdiode (LD) anliegen würde, aufgetrennt zu werden, um die Laserdiode (LD) zu schützen.

2. Laserdiodenschaltung nach Anspruch 1, **dadurch gekennzeichnet, dass** das elektronische Element ein entsprechend gesteuerter elektronischer Schalter (SD, SL) ist.

3. Laserdiodenschaltung nach Anspruch 1, **dadurch gekennzeichnet, dass** das elektronische Element eine erste Diode (D1) ist.

4. Laserdiodenschaltung nach einem der Ansprüche 1 bis 3, **dadurch gekennzeichnet, dass** der Ladekreis (1) einen steuerbaren zweiten Schalter (S2) aufweist, welcher der Serienschaltung aus elektronischem Element (D1, SD, SL) und Kondensator (C1) parallelgeschaltet ist.

5. Laserdiodenschaltung nach Anspruch 4, **gekennzeichnet durch** einen Impulsgenerator (3), der dafür ausgebildet ist, den ersten Schalter (S1) mit einer ersten Folge (F₁) von Steuerimpulsen (Pᵢ) einer Taktrate (f) und den zweiten Schalter (S2) mit einer zweiten, der ersten vorauseilenden Folge (F₂) von Steuerimpulsen (Qⱼ) derselben Taktrate (f) oder eines Vielfachen davon und jeweils einer Impulsbreite (PWⱼ) zu steuern, die der jeweils aktuellen Amplitude (Aⱼ) eines Modulationssignals (M) entspricht.

6. Laserdiodenschaltung nach Anspruch 5, **gekennzeichnet durch** eine Kompensationsschaltung (8), welche dafür ausgebildet ist, das Modulationssignal (M) umgekehrt proportional zur Spannung (U_{V1}) der Spannungsquelle (V1) zu verändern.

7. Laserdiodenschaltung nach einem der Ansprüche 1 bis 6, **gekennzeichnet durch** einen der Spannungsquelle (V1) parallelgeschalteten Pufferkondensator (CP).

8. Laserdiodenschaltung nach einem der Ansprüche 3 bis 7, **dadurch gekennzeichnet, dass** der Ladekreis (1) einen der Spule (L1) oder ersten Diode (D1) vor- oder nachgeschalteten Ladeschalter (SL) aufweist.

## Claims

1. Laser diode circuit, comprising a charging circuit (1), which is connectable to a voltage source (V1) and has a capacitor (C1), and a load circuit (2), which is powered by the charging circuit (1) and has a laser diode (LD) in forward direction,
wherein the load circuit (2) is connected in parallel with the capacitor (C1) and comprises a controllable first switch (S1) connected in series with the laser diode (LD), and
wherein the charging circuit (1) comprises, in a serial connection, a coil (L1), an electronic element (D1, SD, SL) which allows current to pass to the capacitor (C1) and blocks current in the opposite direction, and the capacitor (C1), **characterized in that**
the load circuit (2) has a second diode (D2), which is not a laser diode, connected in the same forward direction in series with the laser diode (LD), or has a disconnector (ST) connected in series upstream or downstream of the laser diode (LD), which is configured to be disconnected at the end of the recharging process when the laser diode (LD) would have a negative potential in order to protect the laser diode (LD).

2. Laser diode circuit according to claim 1, **characterized in that** the electronic element is a correspondingly controlled electronic switch (SD, SL).

3. Laser diode circuit according to claim 1, **characterized in that** the electronic element is a first diode (D1).

4. Laser diode circuit according to any one of claims 1 to 3, **characterized in that** the charging circuit (1) comprises a controllable second switch (S2) which is connected in parallel with the serial connection of the electronic element (D1, SD, SL) and the capacitor (C1).

5. Laser diode circuit according to claim 4, **characterized by** a pulse generator (3) which is configured to control the first switch (S1) with a first sequence (F₁) of control pulses (Pᵢ) at a clock rate (f) and the second switch (S2) with a second sequence (F₂) of control pulses (Qⱼ), that is ahead of the first sequence, at the same clock rate (f) or a multiple thereof, and at a respective pulse width (PWⱼ) corresponding to the respective present amplitude (Aⱼ) of a modulation signal (M) .

6. Laser diode circuit according to claim 5, **characterized by** a compensation circuit (8) configured to modify the modulation signal (M) inversely proportional to the voltage (U_{V1}) of the voltage source (V1) .

7. Laser diode circuit according to any one of claims 1 to 6, **characterized by** a buffer capacitor (CP) connected in parallel with the voltage source (V1).

8. Laser diode circuit according to any one of claims 3 to 7, **characterized in that** the charging circuit (1) comprises a charging switch (SL) connected upstream of downstream of the coil (L1) or to the first diode (D1).

## Revendications

1. Circuit de diode laser comprenant un circuit de chargement (1), pouvant être raccordé à une source de tension (V1), avec un condensateur (C1), et un circuit de charge (2), alimenté par le circuit de chargement (1), avec une diode laser (LD) dans le sens du passage,
dans lequel le circuit de charge (2) est connecté en parallèle au condensateur (C1) et présente un premier commutateur (S1) commandable en série avec la diode laser (LD), et
dans lequel le circuit de chargement (1) présente en série une bobine (L1), un élément électronique (D1, SD, SL) laissant passer du courant vers le condensateur (C1) et le bloquant en sens inverse et le condensateur (C1), **caractérisé en ce**
**que** le circuit de charge (2) présente une deuxième diode (D2), qui n'est pas une diode laser, connectée dans le même sens de passage en série en amont ou en aval de la diode laser (LD) ou un interrupteur-sectionneur (ST) connecté en série en amont ou en aval de la diode laser (LD) qui est conçu pour, à la fin du processus de rechargement lorsqu'un potentiel négatif était présent sur la diode laser (LD), être sectionné afin de protéger la diode laser (LD).

2. Circuit de diode laser selon la revendication 1, **caractérisé en ce que** l'élément électronique est un commutateur électronique (SD, SL) commandé de manière appropriée.

3. Circuit de diode laser selon la revendication 2, **caractérisé en ce que** l'élément électronique est une première diode (D1).

4. Circuit de diode laser selon l'une des revendications 1 à 3, **caractérisé en ce que** le circuit de chargement (1) présente un deuxième commutateur (S2) commandable, lequel est connecté en parallèle au circuit en série à base de l'élément électronique (D1, SD, SL) et du condensateur (C1).

5. Circuit de diode laser selon la revendication 4, **caractérisé par** un générateur d'impulsions (3) qui est conçu pour commander le premier commutateur (S1) avec une première séquence (F₁) d'impulsions de commande (Pᵢ) d'une fréquence d'horloge (f) et le deuxième commutateur (S2) avec une deuxième séquence (F₂) d'impulsions de commande (Qⱼ), d'avance par rapport à la première, de la même fréquence d'horloge (f) ou un multiple de celle-ci et respectivement d'une largeur d'impulsion (PWⱼ) qui correspond respectivement à l'amplitude (Aⱼ) actuelle d'un signal de modulation (M).

6. Circuit de diode laser selon la revendication 5, **caractérisé par** un circuit de compensation (8), lequel est conçu pour modifier le signal de modulation (M) de manière inversement proportionnelle par rapport à la tension (U_{V1}) de la source de tension (V1).

7. Circuit de diode laser selon l'une des revendications 1 à 6, **caractérisé par** un condensateur tampon (CP) connecté en parallèle à la source de tension (V1).

8. Circuit de diode laser selon l'une des revendications 3 à 7, **caractérisé en ce que** le circuit de chargement (1) présente un commutateur de chargement (SL) connecté en amont ou en aval de la bobine (L1) ou de la première diode (D1).
